# EUROPEAN PATENT APPLICATION

(11) **EP 1 061 572 A1**
(43) Date of publication of application: **20.12.2000**
(21) Application number: 99830372.1
(22) Date of filing: 16.06.1999
(51) Int. Cl.: H01L 21/74, H01L 27/082, H01L 21/8222

(54) **Intergrated stucture for radio frequency applications**

(71) Applicant: STMicroelectronics S.r.l., 20041 Agrate Brianza (Milano) (IT)
(72) Inventor: Lo Verde, Domenico, 95121 Catania (IT); Santangelo, Antonello, 95032 Belpasso (Catania) (IT)
(74) Representative: Pezzoli, Ennio

(57) **Abstract**

Integrated structure (100) for radio frequency applications, formed in a chip of semiconductor material, comprising a substrate (103) having a first type of conductivity (P) on which at least one epitaxial layer (109, 118) is grown, at least one connecting region (106) having the first type of conductivity (P) extending from a free surface of the at least one epitaxial layer (109, 118) to the substrate (103), to form an insulating region which demarcates a portion of the at least one epitaxial layer (109, 118) in which a bipolar transistor (Tp) is formed, the transistor (Tp) comprising a collector region (115, 118, 127) having a second type of conductivity (N) delimited by the free surface and by the connecting region (106), a base region having the first type of conductivity (P) extending from the free surface into the collector region (115, 118, 127), and an emitter region having the second type of conductivity (N) extending from the free surface into the base region, in which are included conducting means (148, 157e) in contact on the free surface with one of the base region and the emitter region, and with the connecting region (106), to electrically connect the said one region to the substrate (103).

## Description

The present invention relates to an integrated structure for radio frequency applications.

Integrated structures, for example those suitable for operation at a power of more than 500 mW, are widely used in radio frequency applications, in which the operating frequency is generally of the order of several GHz. Typically, these applications require the use of an amplifier stage with bipolar junction transistors (BJT) of the fast type, with a very high cut-off frequency (greater than 20 GHz, for example); these transistors have their emitter or base terminals connected to reference (or ground) terminals in a common-emitter or common-base configuration respectively.

The integrated structure is formed in a chip of semiconductor material which is housed in a suitable metal container (case); in particular, a bottom surface of the chip is fixed to the metal case, which is typically connected to ground. A plurality of transistors is generally provided in the chip of semiconductor material; each transistor is formed within a corresponding insulation well, with the collector terminal, the base terminal and the emitter terminal located on an upper surface of the chip (opposite the bottom surface) .

The emitter terminal or base terminal is connected to the metal case (and consequently to the ground terminal) by means of metal wires. These metal wires introduce parasitic inductances which adversely affect the operating characteristics of the corresponding complete electronic device; this generally makes it necessary to use a plurality of metal wires (connected in parallel with each other) in such a way as to reduce the total parasitic inductance. In all cases, the process of encapsulation of the structure becomes more complicated and difficult, thus increasing the cost of the electronic device.

Moreover, the known integrated structures occupy a not insignificant area on the chip of semiconductor material. The large dimensions of the chip of semiconductor material make it necessary to use relatively large metal cases which adversely affect the performance of the electronic device, since they introduce parasitic capacitances and further parasitic inductances.

The object of the present invention is to overcome the aforesaid drawbacks. To achieve this object, an integrated structure for radio frequency applications as described in the first claim is proposed.

Briefly, the present invention provides an integrated structure for radio frequency applications, formed in a chip of semiconductor material comprising a substrate having a first type of conductivity on which at least one epitaxial layer is grown, at least one connecting region having the first type of conductivity extending from a free surface of the at least one epitaxial layer to the substrate, to form an insulating region which demarcates a portion of the at least one epitaxial layer in which a bipolar transistor is formed, the transistor comprising a collector region having a second type of conductivity delimited by the free surface and by the connecting region, a base region having the first type of conductivity extending from the free surface into the collector region, and an emitter region having the second type of conductivity extending from the free surface into the base region, in which are included conducting means in contact on the free surface with one of the base region and the emitter region, and with the connecting region, to electrically connect the said one region to the substrate.

The present invention also proposes an electronic device comprising this integrated structure and a corresponding method for producing the integrated structure.

Further characteristics and the advantages of the integrated structure according to the present invention will be revealed by the following description of a preferred embodiment of the invention, provided for information and without implying any restriction, with reference to the attached figures, in which:
Figs. 1a-1e show the different stages of a process of producing the integrated structure;
Fig. 1f is a plan view of the integrated structure;
Figs. 2a-2c are qualitative diagrams of different doping profiles of the integrated structure;
Fig. 3 shows an electronic device comprising the integrated structure.

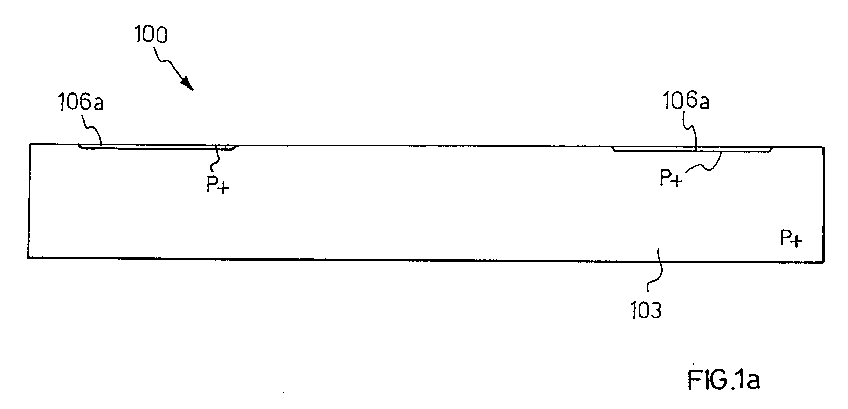

Considered jointly, Figs. 1a-1e (the elements common to the different figures are identified by the same reference numbers) show an integrated power structure 100 for radio frequency applications, used for example in the field of analog and digital telephony, cordless telephony, satellite television, radar detectors, highfrequency oscillators, and the like. The integrated structure 100 is formed in a chip of semiconductor material; typically, the same structure is formed in large numbers in a plurality of identical areas of a wafer of semiconductor material, which are subsequently separated by a slicing operation. As usual, the concentrations of the N and P type impurities are indicated by adding the sign + or the sign - to the letters N and P to indicate a high or low concentration of impurities respectively; the letters N and P without the addition of the signs + or - denote an intermediate level of concentration.

With reference to Fig. 1a in particular, the chip comprises a substrate 103, consisting of monocrystalline silicon highly doped with P type impurities (P+), for example boron, in such a way as to provide a resistivity of the order of 10-20 mΩ·cm. A P+ type region 106a, doped for example with boron at 1E16 atoms/cm², is formed on an upper surface of the substrate 103 and extends in plan view in the form of a frame. In particular, the upper surface of the substrate 103 is subjected to an oxidation process which produces the growth of a layer of silicon dioxide. A layer of photo-sensitive material (photoresist) is deposited on the oxide layer and is then shaped by a photolithographic masking process in such a way as to create a window at the position of the region to be formed. The oxide layer which remains exposed is etched, and the impurities are implanted through this window. The layer of photosensitive material is stripped and a stage of annealing the implanted impurities is carried out; the oxide layer is then completely removed.

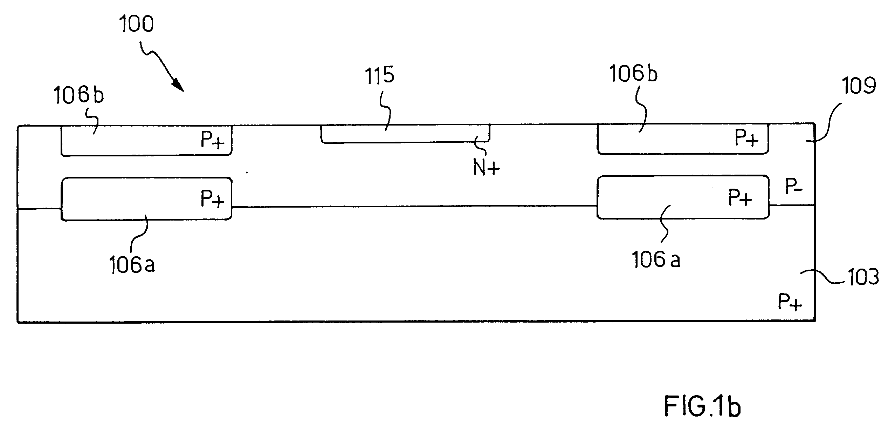

Moving on to Fig. 1b, a layer 109 of the same type of conductivity but with a low concentration of impurities (P-), having a thickness of 7-8 µm, is formed on the substrate 103 by epitaxial growthing. In particular, the epitaxial layer 109 is formed by a stage of growing an intrinsic monocrystalline silicon layer, followed by a stage of growing a layer of monocrystalline silicon doped with boron at 1.5E15 atoms/cm², in such a way as to produce a resistivity of the order of 9 Ω·cm. In this stage, which is carried out at a high temperature, the P type impurities implanted previously (region 106a) diffuse further into the substrate 103 and into the epitaxial layer 109.

A P+ type region 106b is formed on an upper surface of the epitaxial layer 109 by a photolithographic masking process, a stage of ionic implantation and a stage of diffusion; the region 106b is doped, for example, with boron at 2E16 atoms/cm², and is superimposed in plan view on the region 106a. An N+ type region 115 is formed similarly, being doped for example with arsenic at 5E15 atoms/cm² and located in plan view within the region 106b. At the end of the process, any oxide layer present on the upper surface of the epitaxial layer 109 is completely removed.

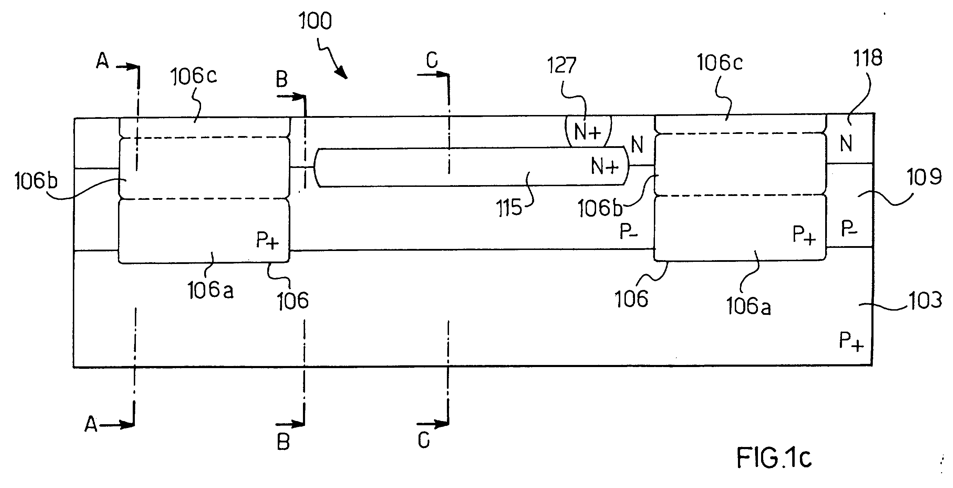

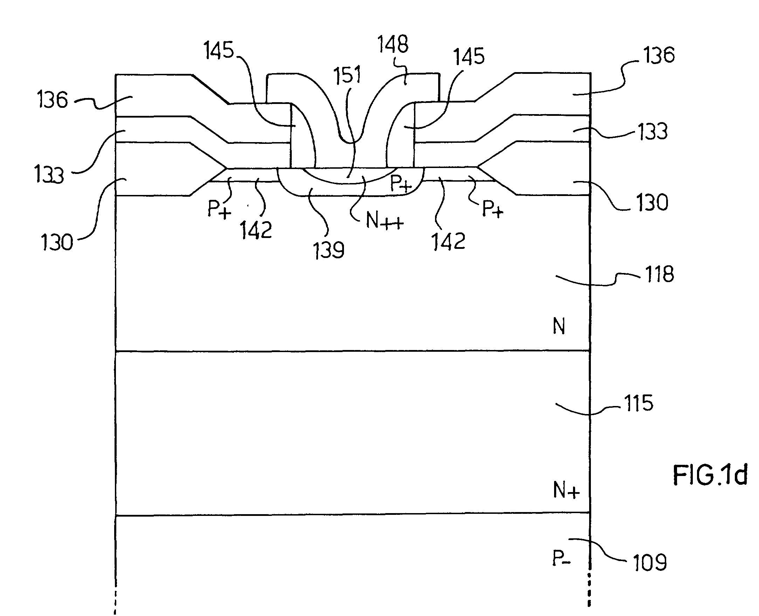

Passing on to Fig. 1c, a further N type epitaxial layer 118, doped for example with phosphorus at 4.9E15 atoms/cm³ (to provide a resistivity of the order of 1 Ω·cm) and with a thickness of 1-1.5 µm, is grown on the upper surface of the epitaxial layer 109. In this stage, which is carried out at a high temperature, the N type impurities implanted previously (region 115) diffuse further into the two epitaxial layers 109, 118, creating a buried region; simultaneously, the regions 106a and 106b are partially joined. A P+ type region 106c is formed on a free upper surface of the epitaxial layer 118 by a photolithographic masking process, an ionic implantation stage and a diffusion stage; the region 106c, doped for example with boron at 1E16 atoms/cm², is superimposed in plan view on the region 106b and is partially joined to it.

The regions 106a, 106b and 106c which are joined together form a connecting region (sinker), indicated as a whole by 106, which extends from the upper surface of the epitaxial layer 118 to the substrate 103. The connecting region 106 and the substrate 118 form an insulating region which demarcates a portion of the epitaxial layers 109, 118 (comprising the buried region 115).

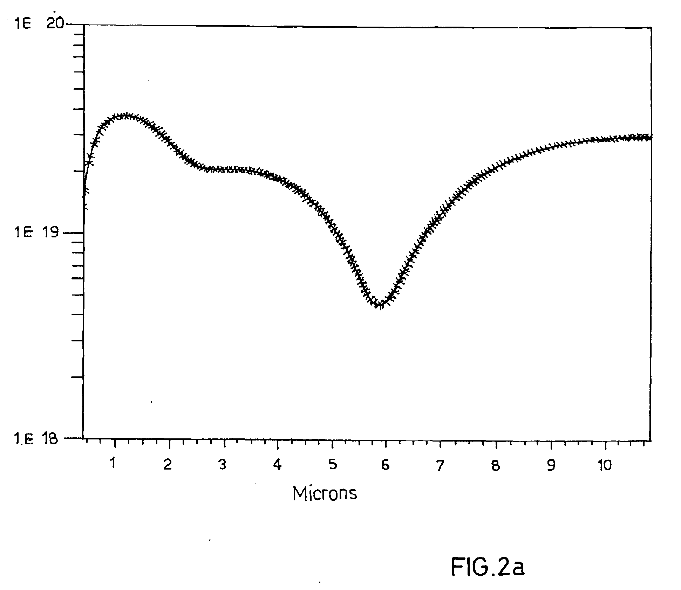

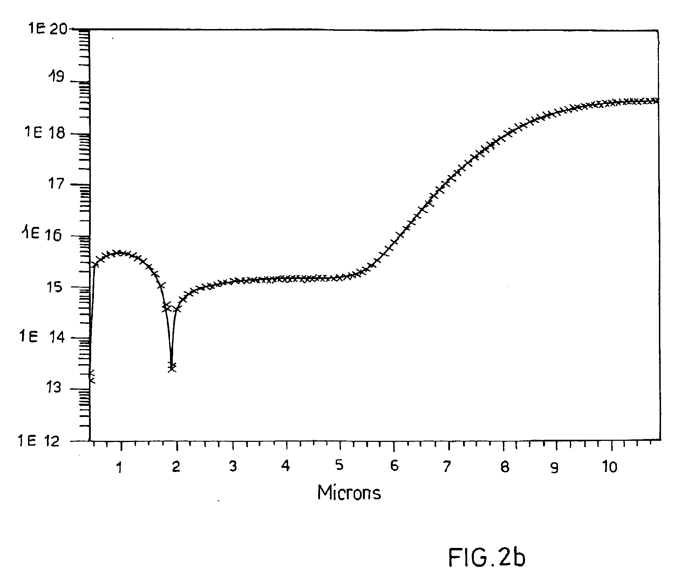

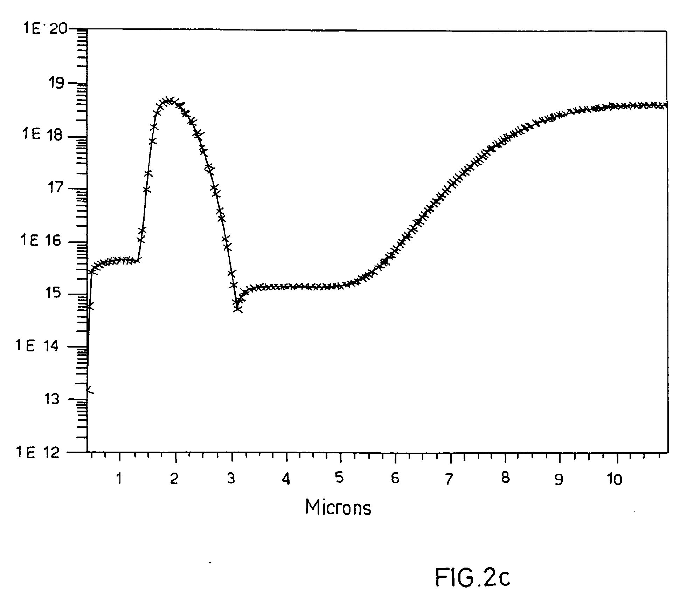

By way of example, Fig. 2a shows a doping profile of the chip along the connecting region (section A-A in Fig. 1c); in particular, the horizontal axis shows the depth (in µm) and the vertical axis shows the concentration of impurities (in atoms/cm³). Similarly, Fig. 2b shows the doping profile of the chip along the portion of the epitaxial layers demarcated by the insulating region (section B-B in Fig. 1c), and Fig. 2c shows the doping profile of the chip along the same portion of the epitaxial layers comprising the buried region (section C-C in Fig. 1c).

Returning to Fig. 1c, a bipolar transistor is formed in the portion of the epitaxial layers 109, 118 demarcated by the insulating region 103, 106. The transistor is formed by a double polysilicon self-aligned (or DPSA) technology. In particular, an N+ type connecting region 127 is formed, extending from the upper surface of the epitaxial layer 118 to the buried region 115. With reference to the view in Fig. 1d of an enlarged detail of the integrated structure, the upper surface of the epitaxial layer 118 (within the insulating region) is covered with a layer of silicon oxide 130 in which a window is created. A layer of polysilicon 133, doped with P type impurities (boron, for example) in the deposition stage or by means of a process of implantation over the whole of its free surface, is deposited and shaped in such a way that it is located, in plan view, within the insulating region and has a portion in contact with the epitaxial layer 118. A layer of dielectric material 136, for example silicon dioxide, is then deposited. A window is created by a photolithographic masking process and an etching stage in the layer of polysilicon 133 and in the layer of dielectric material 136, this window being located, in plan view, within the portion of the polysilicon layer 133 in contact with the epitaxial layer 118. A P+ type region 139 is then implanted through this window into the epitaxial layer 118. A thermal process (including an oxidation stage) is then carried out, during which the P type impurities diffuse from the polysilicon layer 133 into the epitaxial layer 118, to form a P+ type region 142 located, in plan view, around the region 139, and the previously implanted impurities (region 139) are activated and diffused. A spacer 145 (made from dielectric material) is then formed on the side walls of the window. A polysilicon layer 148 doped with N type impurities is deposited and shaped in such a way that it is in contact with a central portion of the region 139. A further thermal process is then carried out, during which the N type impurities diffuse from the polysilicon layer 148 into the region 139 to form an N++ type region 151.

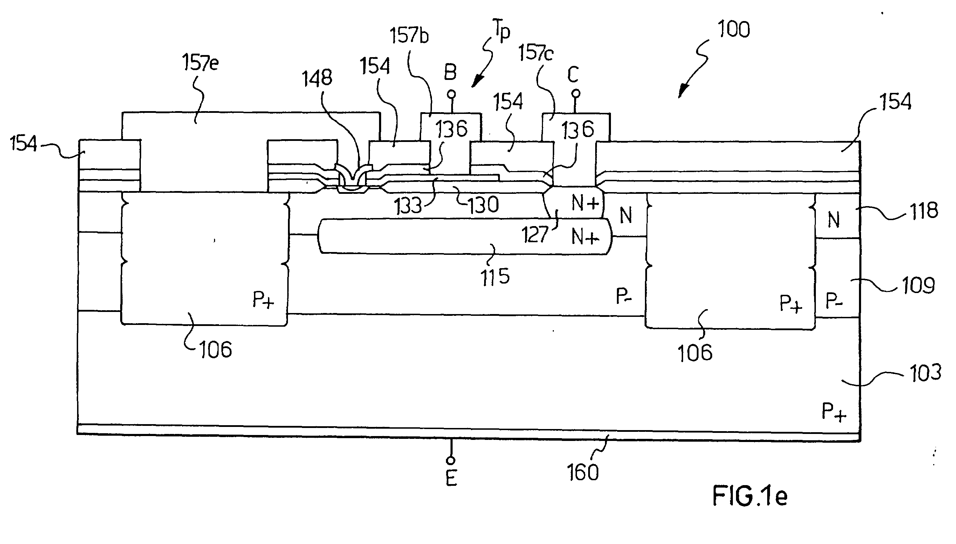

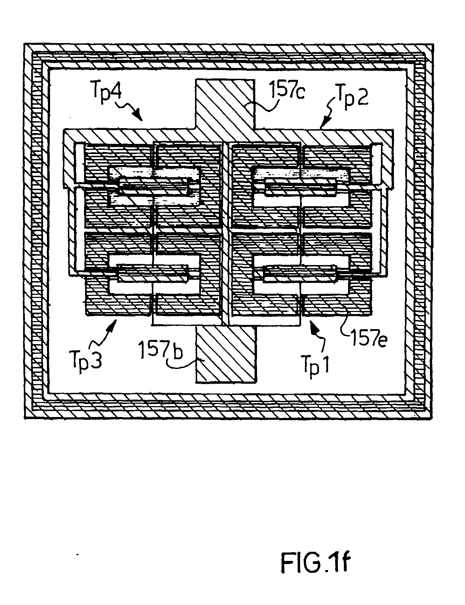

Returning to an overall view of the integrated structure as shown in Fig. 1e, during the thermal processes described above the regions 106a, 106b and 106c diffuse further, joining together uniformly in such a way that the connecting region 106 has a very low resistivity. The chip is covered with a layer of dielectric material 154 (silicon oxide, for example) which is planarized by a chemical-mechanical polishing (or CMP) process; alternatively, a dielectric material is used which flows at relatively low temperatures (such as silicon oxide doped with boron and phosphorus, or BPSG), or a material is deposited in the liquid state and the wafer of semiconductor material is then centrifuged, in such a way that the dielectric material spreads over the whole surface, after which it is dried. Contact windows are then created, by a photolithographic masking process and an etching stage, in the layer of dielectric material 154 for metallic tracks (made from aluminium, for example), formed by successive photolithographic masking processes, deposition stages and etching stages. In particular, a metallic track 157e contacts (and interconnects) the polysilicon layer 148 and the connecting region 106, a metallic track 157b contacts the polysilicon layer 133, and a metallic track 157c contacts the connecting region 127. Finally, a metallic layer 160 (made from gold, for example) is deposited on a free surface of the substrate 103.

The integrated structure 100 described above includes an NPN bipolar transistor Tp. In particular, the collector region consists of the portion of the epitaxial layer 118 demarcated by the insulating region 103, 106 (delimited by the upper surface of the epitaxial layer 118 and by the connecting region 106), by the buried region 115 and by the connecting region 127 (which guide the collector current along a low-resistance path, in such a way as to reduce the saturation voltage of the transistor Tp); the metallic track 157c (connected to the connecting region 127) forms a collector terminal C of the transistor Tp. With reference to Figs. 1e and 1d jointly, the region 139 is an intrinsic base region, which forms the actually active region in the operation of the transistor Tp. The region 142 is an extrinsic base region which, together with the polysilicon layer 133, connects the intrinsic base region 139 along a low-resistance path to the metallic track 157b, which forms a base terminal B of the transistor Tp. The P-N junction formed by the regions 139 and 151 forms a base-emitter junction of the transistor Tp, while the polysilicon layer 148 is a polycrystalline emitter region, which is connected to the metallic track 157e; the metallic layer 160 (connected electrically to the metallic track 157e through the substrate 103 and the connecting region 106) forms an emitter terminal E of the transistor Tp.

The transistor Tp is insulated from a remaining part of the chip of semiconductor material. This is because, in an operating condition, the emitter terminal E and the collector terminal C are connected, respectively, to the ground terminal and to the positive terminal of a power source (whose negative terminal is connected to the ground terminal), so that the P-N junction formed by the insulating region 103, 106 and the portion of the epitaxial layer 109 (P type regions) and by the buried region 115 and the portion of the epitaxial layer 118 (type N regions) is reverse biased.

Similar considerations are applicable in cases where the transistor is produced by another process or is not made by DPSA technology, or other stages are provided for the formation of the integrated structure, or the thickness of the epitaxial layers and the concentrations of impurities have a different value, or the integrated structure includes a different number of epitaxial layers (down to a minimum of one), or the structure is formed with the P and N type regions interchanged, or the like.

In the integrated structure 100 described above, the polysilicon layer 148 and the metallic track 157e are in contact on the upper surface of the epitaxial layer 118 with the emitter region (indicated by 151 in Fig. 1d) and with the connecting region 106, so that the emitter region is connected electrically to the substrate 103. Alternatively, the metallic track 157e is connected only to the polysilicon layer 148 (so that it forms the emitter terminal of the transistor), while the metallic track 157b is connected to the connecting region 106; in this way, the base region (indicated by 139, 142 in Fig. 1d) is connected electrically to the substrate 103, and the metallic layer 160 forms the base terminal of the transistor. More generally, in the integrated structure according to the present invention, conducting means are provided in contact with one of the base region and the emitter region, and with the connecting region 106, to electrically connect this region (base or emitter) to the substrate 103.

The emitter region or the base region is thus connected electrically to the bottom surface of the chip, consisting, in the illustrated example, of a free surface of the metallic layer 160. This result is obtained directly within the said chip of semiconductor material, without any additional external connection.

The solution according to the present invention uses the connecting region already present in the integrated structure, so that no greater occupation of space is required. Furthermore, the connecting region has a very low resistance, so that an emitter (or base) series resistance of the transistor is kept low.

In the embodiment shown in the figure, a portion of the epitaxial layer 109 which has a very low concentration of impurities is provided within the insulating region 103, 106. Thus a depletion layer formed between the collector region 115, 118, 127 and the region 103, 109, 106 (connected to the emitter region) extends a considerable depth into the portion of the epitaxial layer 109, so that a parasitic capacitance between the collector region and the emitter region has a very low value (being inversely proportional to the width of the depletion layer). The epitaxial layer 109 also increases the breakdown voltage between the collector and emitter with an open base (Breakdown voltage collector-emitter open base, or Bvceo), or the breakdown voltage between the collector and base with an open emitter (Breakdown voltage collector-base open emitter, or Bvcbo) of the transistor Tp. However, the integrated structure according to the present invention can also be produced without this epitaxial layer.

The solution according to the present invention is particularly advantageous in a case where the integrated structure includes a plurality of transistors (similar to that described above) connected in parallel with each other to form a single power component (although its use in the case in which the integrated structure comprises a single transistor is not excluded). With reference to Fig. 1f, four bipolar transistors Tp1, Tp2, Tp3 and Tp4 are provided, for example (similar considerations are applicable in the case in which a different number of transistors is provided), each of which is formed in a corresponding insulating region and constitutes an elementary cell of the power component. The collector regions and the base regions of the transistors Tp1-Tp4 are connected, respectively, to single metallic tracks 157c and 157b; each of the metallic tracks 157c and 157b has a pad forming the collector terminal and base terminal, respectively, of the power component. The metallic tracks 157e, on the other hand, connect the emitter regions of the transistors Tp1-Tp4 (through the corresponding connecting regions) to the emitter terminal of the power component, located on the free surface of the substrate.

The solution described above makes it possible to eliminate from an upper surface of the chip the pad which forms the emitter terminal and the corresponding metallic tracks for connection to the emitter regions of the transistors Tp1-Tp4; this considerably reduces the dimensions of the integrated structure. This result is also obtained with a single layer of metallization (or another equivalent conducting material) on the upper surface of the chip.

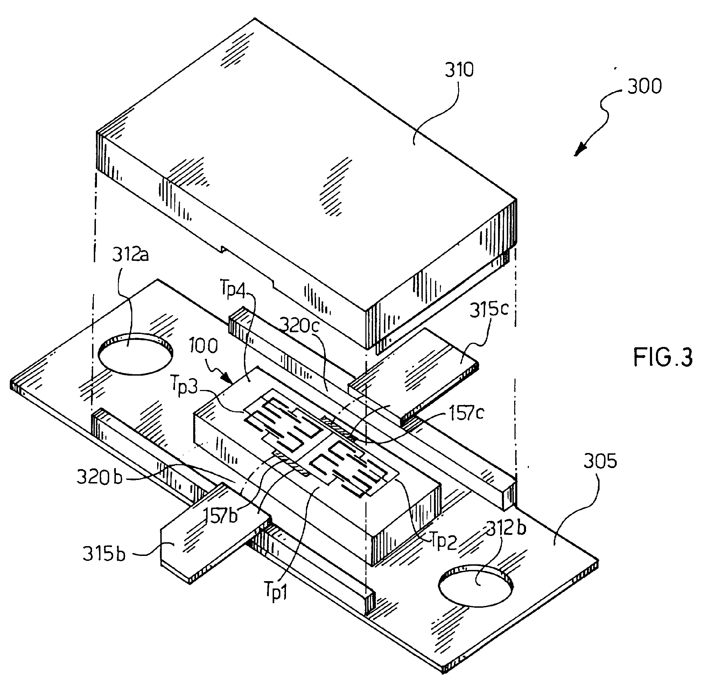

With reference now to Fig. 3, an electronic power device for radio frequency applications 300 is illustrated. The device 300 includes a metal case in which the integrated structure 100 is housed and which is formed by a plate 305, which acts as a heat sink, enclosed above by a cover (body) 310. Two fixing holes 312a and 312b are made near the longitudinal ends of the heat sink 305.

The bottom surface of the chip is fixed directly to the heat sink 305 (connected to ground). Two insulated metal plates 315b and 315c are also connected to the heat sink 305 and project externally from the metal case 305, 310; the metal plate 315b has a portion cut off at one outer corner, to distinguish it visually from the metal plate 315c. Metal wires 320b and 320c electrically connect the metallic tracks 157b and 157c respectively to inner ends of the corresponding metal plates 315b and 315c (wire bonding). The integrated structure 100 is encapsulated in the metal case 305, 310 by soldering the cover 310 to the heat sink 305. The heat sink 305 forms an external emitter terminal of the device 300, while the metal plates 315b and 315c form the external base and collector terminals respectively. Similar considerations are applicable in the case in which another equivalent metal case is used.

The electronic device comprising the integrated structure according to the present invention has a smaller number of metal wires and makes it possible to use a metal case having small dimensions, as a result of which it has extremely low parasitic inductances and capacitances.

Clearly, a person skilled in the art may, in order to meet contingent and specific requirements, make numerous modifications to, and variations of, the integrated structure for radio frequency applications described above, all these modifications and variations being contained within the scope of protection of the invention, as defined by the following claims.

## Claims

1. Integrated structure (100) for radio frequency applications, formed in a chip of semiconductor material comprising a substrate (103) having a first type of conductivity (P) on which at least one epitaxial layer (109, 118) is grown, at least one connecting region (106) having the first type of conductivity (P) extending from a free surface of the at least one epitaxial layer (109, 118) to the substrate (103), to form an insulating region which demarcates a portion of the at least one epitaxial layer (109, 118) in which a bipolar transistor (Tp) is formed, the transistor (Tp) comprising a collector region (115, 118, 127) having a second type of conductivity (N) delimited by the free surface and by the connecting region (106), a base region (139, 142) having the first type of conductivity (P) extending from the free surface into the collector region (115, 118, 127), and an emitter region (151) having the second type of conductivity (N) extending from the free surface into the base region (139, 142)
characterized in that
it includes conducting means (148, 157e) in contact on the free surface with one (151) of the base region and the emitter region, and with the connecting region (106), to electrically connect the said one region (151) to the substrate (103).

2. Integrated structure (100) according to Claim 1, in which the at least one epitaxial layer (109,118) consists of a first epitaxial layer (109) having the first type of conductivity (P) located on the substrate (103), the first epitaxial layer (109) having a concentration of impurities (P-) which is lower than a concentration of impurities (P+) of the substrate (103), and a second epitaxial layer (118) having the second type of conductivity (N) and located on the first epitaxial layer (109), the collector region (115,118,127) comprising the portion of the second epitaxial layer (118).

3. Integrated structure (100) according to Claim 2, in which the collector region (115,118,127) further includes a region (115) having the second type of conductivity (N) which is buried between the first (109) and the second (118) epitaxial layer, the buried region (115) having a concentration of impurities (N+) which is greater than a concentration of impurities (N-) of the second epitaxial layer (118).

4. Integrated structure (100) according to Claim 3, in which the collector region (115, 118, 127) includes a further connecting region (127) extending from the free surface to the buried region (115), in which the base region (139, 142) includes an intrinsic base region (139) extending from the free surface into the portion of the second epitaxial layer (118), an extrinsic base region (142) extending from the free surface into the portion of the second epitaxial layer (118) and located, in plan view, around the intrinsic base region (139), and in which the emitter region (151) extends from the free surface into the intrinsic base region (139), the transistor (Tp) additionally comprising a first layer of polysilicon (133) in contact on the free surface with the extrinsic base region (142) and a second layer of polysilicon (148) in contact on the free surface with the emitter region (151), the conducting means (148, 157e) comprising a metallic track (157e) in contact with the layer of polysilicon (148) corresponding to the said one region (151).

5. Integrated structure (100) according to any one of Claims 1 to 4, further comprising a collector terminal (157c), a base terminal (157b) and an emitter terminal (157e) connected, respectively, to the collector region (115, 118, 127), to the base region (139, 142) and to the emitter region (151), the terminal (157e) connected to the said one region (151) being located on a free surface of the substrate (103) and the other terminals (157c, 157b) being located on the free surface of the at least one epitaxial layer (109, 118).

6. Integrated structure (100) according to Claim 5, comprising a plurality of the said transistors (Tp1-Tp4) connected in parallel with each other to a single collector terminal (157c), to a single base terminal (157b) and to a single emitter terminal (157e) by means of a single conducting layer (157c, 157b, 157e) located on the free surface and comprising the said conducting means (157e).

7. Electronic device (300) for radio frequency applications, comprising a metal case (305, 310) in which is housed the integrated structure (100) according to any one of Claims 1 to 6, the substrate (103) being fixed to the metal case (305, 310) to electrically connect the said one region (151) to the metal case (305, 310).

8. Process for producing an integrated structure (100) for radio frequency applications in a chip of semiconductor material, comprising the steps of:
providing a substrate (103) having a first type of conductivity (P),
growing at least one epitaxial layer (109, 118) on the substrate (103),
forming at least one connecting region (106) having the first type of conductivity (P) and extending from a free surface of the at least one epitaxial layer (109, 118) to the substrate (103) to form an insulating region which demarcates a portion of the at least one epitaxial layer (109, 118),
forming a bipolar transistor (Tp) in the portion of the at least one epitaxial layer (109, 118), the transistor (Tp) comprising a collector region (115, 118, 127) having a second type of conductivity (N) delimited by the free surface and by the connecting region (106), a base region (139, 142) having the first type of conductivity (P) and extending from the free surface into the collector region (115, 118, 127), and an emitter region (151) having the second type of conductivity (N) and extending from the free surface into the base region (139, 142),
characterized by the step of
forming conducting means (148, 157e) in contact on the free surface with one (151) of the base region and the emitter region, and with the connecting region (106), to electrically connect the said one region (151) to the substrate (103).

9. Process according to Claim 8, further comprising the steps of:
forming on a surface of the substrate (103) a first region (106a) having the first type of conductivity (P) arranged, in plan view, in the form of a frame,
growing a first epitaxial layer (109) having the first type of conductivity (P) on the surface of the substrate (103), the first epitaxial layer (109) having a concentration of impurities (P-) lower than a concentration of impurities of the substrate (P+),
forming on a surface of the first epitaxial layer (109) opposite the surface of the substrate (103) a second region (106b) having the first type of conductivity (P), superimposed in plan view on the first region (106a),
growing a second epitaxial layer (118) having the second type of conductivity (N) on the surface of the first epitaxial layer (109),
forming, on the said free surface consisting of a surface of the second epitaxial layer (118) opposite the surface of the first epitaxial layer (109), a third region (106c) having the first type of conductivity (P), superimposed in plan view on the second region (106b),
the first (106a), the second (106b) and the third (106c) regions forming the connecting region (106).

10. Process according to Claim 9, further comprising the step of forming on the surface of the first epitaxial layer (109) a region (115) having the second type of conductivity (N) located in plan view within the second region (106b) to produce a buried region (115) between the first (109) and the second (118) epitaxial layer, the buried region (115) having a concentration of impurities (N+) greater than a concentration of impurities (N-) of the second epitaxial layer (118).
